# EUROPEAN PATENT APPLICATION

(11) **EP 4 366 473 A1**
(43) Date of publication of application: **08.05.2024**
(21) Application number: 23176785.6
(22) Date of filing: 01.06.2023
(51) Int. Cl.: H05K 1/02, H05K 1/11, H05K 3/00

(54) **EVALUATING THE HEALTH CONDITION OF A SINGLE COMPONENT CARRIER**

(30) Priority: 02.11.2022 CN 202211362481; 02.11.2022 EP 22205092
(71) Applicant: AT & S Austria Technologie & Systemtechnik Aktiengesellschaft, 8700 Leoben-Hinterberg (AT)
(72) Inventor: Krivec, Thomas, 8740 Zeltweg (AT); Stubenberger, Gehard, 8700 Leoben (AT); Weis, Gerald, 8600 Bruck an der Mur (AT); Zuendel, Julia, 8700 Leoben (AT); Galler, Christian, 8700 Leoben (AT); Fendt, Karl Thomas, 8042 Graz (AT)
(74) Representative: Dilg, Haeusler, Schindelmann Patentanwaltsgesellschaft mbH

(57) **Abstract**

There is described a single component carrier (100), comprising: a stack (101) comprising at least one electrically conductive layer structure (104) and at least one electrically insulating layer structure (102), wherein the at least one electrically conductive layer structure (104) comprises a sub-portion (150),
i) wherein said sub-portion (150) is electrically separated or separable from the rest of said electrically conductive layer structure (104);
ii) wherein said sub-portion (150) comprises a region (155) degrading along the time;
iii) wherein said sub-portion (150) comprises two extremities, and
iv) wherein each of said extremities is electrically connected to a respective connecting area (140) exposed on one of the main surfaces of at least one electrically insulating layer structure (102).

Further, there is described a package, an electronic panel, and a method to evaluate the health condition of a single component carrier (100).

## Description

### Field of the Invention

The invention relates to a single component carrier with a stack having an electrically conductive layer structure with a specific sub-portion. The invention also relates to a package and an electronic panel that respectively comprise the single component carrier. Further, the invention relates to a method to check the health of the single component carrier, in particular using a testing device.

Thus, the invention may relate to the technical field of component carriers such as printed circuit boards and IC substrates, in particular in the context of testing the health condition of a single component carrier.

### Technical Background

In the context of growing product functionalities of component carriers equipped with one or more electronic components and increasing miniaturization of such electronic components as well as a rising number of electronic components to be mounted on the component carriers such as printed circuit boards, increasingly more powerful array-like components or packages having several electronic components are being employed, which have a plurality of contacts or connections, with ever smaller spacing between these contacts. Removal of heat generated by such electronic components and the component carrier itself during operation becomes an increasing issue. At the same time, component carriers shall be mechanically robust and electrically and magnetically reliable so as to be operable even under harsh conditions.

In particular, health monitoring of a component carrier such as a printed circuit board or an IC substrate is getting more and more in the focus. Conventionally, component carrier products do not comprise any active/passive health monitoring feature. Research and development conducted in this field is very limited as well, so that there is conventionally no proper health monitoring, in particular regarding prediction of Remaining useful Life (RUL), possible for component carrier (products).

### Summary of the Invention

There may be a need to evaluate the health condition of a single component carrier in an efficient and reliable manner.

A component carrier, a package, an electronic panel, and a method are provided.

According to a first aspect of the invention, there is described a single component carrier, comprising a stack (in particular comprising a plurality of layer structures) comprising at least one electrically conductive layer structure (e.g. an area and/or a volume of metal traces) and at least one electrically insulating layer structure (e.g. a resin layer). Hereby, the at least one electrically conductive layer structure comprises a sub-portion.
i) said sub-portion is electrically separated or separable from the rest of said electrically conductive layer structure;
ii) said sub-portion comprises an area/region degrading along the time;
iii) said sub-portion comprises two extremities (e.g. with respect to the corresponding circuit defined by said electrically conductive layer structure sub-portion or with respect to the thickness extension), and
iv) each of said extremities is electrically connected to a respective connecting area (exposed) on one of the main surfaces (in particular on the same) of the at least one electrically insulating layer structure.

According to a second aspect of the invention, there is described a package, wherein said package comprises i) a single component carrier as described above, and ii) a testing device, wherein said testing device is electrically connected and/or connectable to the (exposed) connecting areas.

According to a third aspect of the invention, there is described an electronic panel, comprising a stack comprising at least one electrically conductive layer structure and at least one electrically insulating layer structure, and is configured to be subsequently singularized in several single component carries (in particular in several equal single component carriers), each configured as described above.

According to a fourth aspect of the invention, there is described a method to evaluate the health condition of a single component carrier (in particular as described above), said single component carrier comprising a stack comprising at least one electrically conductive layer structure and at least one electrically insulating layer structure, wherein a sub-portion of the at least one electrically conductive layer structure comprises an area and/or volume degrading along the time, wherein said sub-portion comprises two extremities, and wherein each of said extremities is connected to a respective connecting area provided on one of the main surfaces of the at least one electrically insulating layer structure. The method comprises:
i) providing a testing device and connecting said testing device to said respective (exposed) connecting areas (in particular through the connection of the device testing probes and the respective exposed connecting areas);
ii) measuring electrical values (parameters) associated with said sub-portion; and
iii) evaluating the health condition of the single component carrier based on the measured electrical values.

According to a fifth aspect of the invention, there is described a computer-readable medium, in which a computer program of evaluating the health condition of a single component carrier is stored, which computer program, when being executed by one or a plurality of processors, is adapted to carry out or control a method as described above.

According to a sixth aspect of the invention, there is described a program element of evaluating the health condition of a single component carrier, which (computer) program element, when being executed by one or a plurality of processors, is adapted to carry out or control a method as described above.

In the context of the present document, the term "component carrier" may particularly denote any support structure which is capable of accommodating one or more components thereon and/or therein for providing mechanical support and/or electrical connectivity. In other words, a component carrier may be configured as a mechanical and/or electronic carrier for components. In particular, a component carrier may be one of a printed circuit board, an organic interposer, and an IC (integrated circuit) substrate. A component carrier may also be a hybrid board combining different ones of the above mentioned types of component carriers.

In the context of the present document, the term "single component carrier" may in particular refer to a component carrier (see definition above), where the essential, in particular all, manufacturing steps for the component carrier formation have been completed. For example, a single component carrier may be seen as a final product of the component carrier manufacture, in particular a product ready for shipping or already delivered to a customer. A single component carrier may be a discrete component carrier, not interconnected with other component carrier, as it may be the case during component carrier manufacture. For example, the single component carrier may be a component carrier after singularization/dicing of a component carrier panel. A single component carrier may hence be e.g. a component carrier, whereby the proper components have already been mounted on one or several (main) surfaces. Thus, the single component carrier may already be suitable to be mounted on the final seat/position. In an example, the single component carrier has a single structure and a single functionality that is not repeated within the carrier itself as a (regular, patterned) series of electrically conductive layer structures, one the same of the other, so that the portions of that carrier can allow a subsequent singularization of well-working sub-carriers. In a further example, the single component carrier can have a peripheral surface without exposing electrically conductive portions, with the eventual exceptions of electric conductive structures (preferably on one of the two main surfaces of the component carrier) configured to allow the electrical connection of a connector device and/or a component assembled on the periphery of the component carrier (also another PCB or IC substrate may be connected if the single component carrier is e.g. an interposer or it may be connected to a motherboard). In a further example, a single component carrier can have an external planar profile following the external planar extension of the electrically conductive layer structures, with the eventual exception of areas suitable for the component carrier assembly/ reinforcement.

In the context of the present document, the term "sub-portion" may in particular refer to a portion of an electrically conductive layer structure (e.g. a patterned copper surface) that may be defined (electrically) separated from a rest of the electrically conductive layer structure. In an example, the sub-portion extends on a common surface (e.g. a single component carrier main surface). In another example, the sub-portion extends at the same vertical position (with respect to the stack thickness direction) as the rest of the electrically conductive layer structure. In a further example, the sub-portion may be located on a peripheral portion (regarding the position in main extension) of the component carrier. Additionally and/or alternatively, the sub-portion may be located on a central portion (regarding the position in main extension) of the component carrier.

In the context of the present document, the term "peripheral portion" may refer to a local position of the component carrier or electronic panel, which is in close proximity to an edge of a main surface and a side wall of the component carrier or electronic panel. For example, a shortest distance from a peripheral portion to said edge of a main surface and a side wall (on the main surface) may be shorter than 40%, in particular shorter than 20%, more in particular shorter than 10%, than a distance from the same position to the center of the total area of a main surface of the component carrier or electronic panel.

In the context of the present document, the term "central portion" may refer to a local position of the component carrier or electronic panel, which is in close proximity to the center of the total area of the component carrier or electronic panel. For example, a shortest distance from a central portion to said center of the total area (on the main surface) may be shorter than 40%, in particular shorter than 20%, more in particular shorter than 10%, than a distance from the same position to an edge of a main surface and a side wall of the component carrier or electronic panel.

In the context of the present document, the term "separated or separable" may in particular refer to the relation between the above defined sub-portion and the rest of the electrically conductive layer structure. In an example, the sub-portion may be separated by being electrically insulated from the rest of the respective electrically conductive layer structure. In a further example, the sub-portion may be part of the same (electrically conductive) layer structure (it has been manufactures in the same process step and with the same material/parameters), but is separated by patterning, so that the sub-portion and the rest of the electrically conductive layer structure are divided. In a further example, the sub-portion may be an additional conductive portion that at least partially overlaps the rest of the respective electrically conductive layer structure along the stack thickness direction. In another example, the electrically conductive layer structure may be separable to allow the separation of the sub-portion from the rest of the electrically conductive layer structure, when electric current is provided through the two extremities of the sub-portion, for example by the use of suitable diodes blocking the electric current passage towards the rest of the electrically conductive layer structure.

In the context of the present document, the term "region degrading along the time (or over time)" may in particular refer to a part (region, portion, volume) of the sub-portion that may be seen as especially prone to degrading; in other words: has a higher risk for degrading/erosion than other areas/regions of the single component carrier. The Remaining useful Life (RUL) of the "region degrading along the time" may be (significantly) shorter than of other areas/regions of the single component carrier. An example of such a "region degrading along the time" may be an area having a small width (of traces) or a high density patterning. A further example may be an area of the sub-portion in contact/bonded/welded (e.g. at an interface) with another area eventually having disassociating features, such as different materials or different shapes or being manufactured in different process steps, or comprising different specific surface features such as roughness, surface tension, additives-material presence, etc.

The term "degradation" may in this context in particular refer to a decreasing of an area of the sub-portion, for example the current passage area and/or contact/bonding/welding area between the sub-portion and a further area. In particular, the degradation may affect the electric value (measured with the testing device) of the electric current passage (through erosion/contact decreasing). In an example, degradation may be caused by chemical reaction with the environment, for example oxidation by air. In another example, degradation may be caused by long-term electrical use, for example use longer than one month, in particular use longer than one year. The degradation can result as a change, for example a decrease of a cross section area (or a region).

The term "connection area" may in this context denote an electrically conductive area (e.g. a pad, a terminal, etc.) that is electrically connected to the sub-portion to be tested. Hence, via the connection area, the sub-portion may be electrically contacted, even if the sub-portion may be (fully) embedded in the stack. According to a further or additional embodiment, the connection area may be formed by a (discontinuous) electrically conductive layer structure. In another example, the connection area may be electrically connected to the sub-portion by additional (testing) interconnections such as vias. In a specific example, the connection area has a square shape, aimed for example to use as much available component carrier surface as possible; more specifically the square testing area of a connection area may be 1*1 mm (or smaller). In the present invention it is anyway not excluded the provisions of other shapes, such as circular, rectangular, or irregular shape. According to an alternative or additional embodiment of the present invention, the shape of the connection areas may be of different shape and/or of different dimensions and/or of different materials/color/roughness i.e. to clearly distinguish this connection area provided for the test reasons from other areas provided on the same side of the component carrier provided for other functions.

In an embodiment, the stack/component carrier surface may comprise a plurality of exposed connection areas, preferably arranged as an array. Thereby, a high number of electrically conductive interconnections (arrangements) may be tested (individually) from the same component carrier side, even though at least some of them may be buried in the stack.

According to an exemplary embodiment, the invention may be based on the idea that the health condition of a single component carrier can be evaluated in an efficient and reliable manner, through a sub-portion of an electrically conductive layer structure (of the component carrier stack), that comprises a region degrading over time, that is electrically connected to exposed connection areas in order to obtain an electric value (e.g. resistance) indicative of the health status of the sub-portion (in particular the region degrading over time).

For example, measuring the electric value of one sub-portion (e.g. a single via) may be sufficient to reliably evaluate the health condition of a single component carrier and allow a prediction of Remaining useful Life, especially in critical applications (e.g. power PCB in critical infrastructure). Based on the described health condition evaluation, a planned maintenance of critical infrastructure may be enabled. The health condition evaluation may be implemented by a simple electronic design without high demand of space and may be applicable to any standard component carrier without the need for new processes.

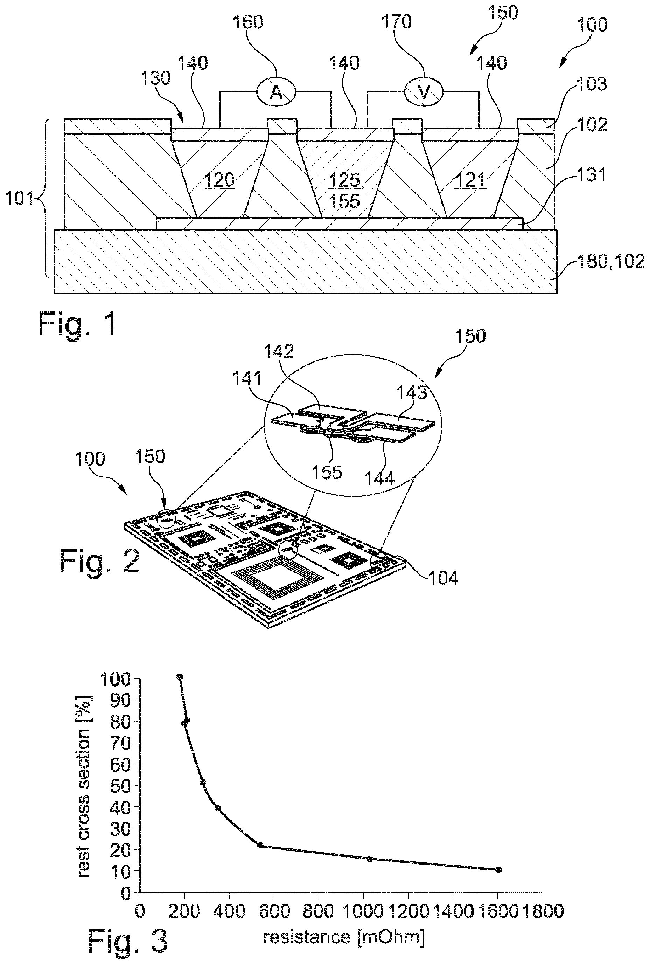

It has been surprisingly found that the measured electrical value, for example resistance, of a suitable sub-portion of an electrically conductive layer structure, can be related reliably to the health condition of a sub-portion with a region degrading over time, such as a via interconnection. So for example, in case of damage propagating in the via (e.g. crack growth) the available conductive cross-section is reduced and the overall resistance of the via feature increases (see Figure 3).

As long as this relationship (e.g. as a so-called damage curve) can be described for specific features, it is possible to take the electrical value as a metric for the health condition. If the geometry of the sub-portion (e.g. a via feature has a diameter not larger than or even slight smaller than the functional vias in the component carrier) and the position of the sub-portion in the component carrier is defined in a suitable way, the sub-portion can be considered as representative for the health status of the full single component carrier.

During operation of the component carrier, especially if the component carrier is applied in applications with a long service life, the sub-portion testing allows identifying the health status of the component carrier and even (e.g. based on the physics of failure of the copper interconnect and/or simulation component carrier life time predictions) to estimate the remaining useful service life of the component carrier.

For the overall electronics systems this evaluation may allow to define/ adjust proper maintenance strategies and avoid unexpected failures and costly downtimes of critical infrastructure.

### Exemplary Embodiments

In an embodiment, the exposed connection area(s) is/are configured to be tested by a four-wire test (FWT) functionality. This may provide the advantage that electric values, in particular the resistance of (individual) electrically conductive interconnections, can be determined in a reliable and efficient manner using established measurement devices.

The four-wire-test may be performed using a current measurement device and a voltage measurement device, thereby determining the resistance indirectly based on the current and the voltage. The name FWT is explained by two wires used by the current measurement device, and two further wires used by the voltage measurement device. In particular, each device contacts two different areas corresponding to two extremities (e.g. top and bottom) of the connecting element (via) to test, otherwise, if two wires are connected to a single connection area, a short junction may be formed.

Therefore, through the use of a known testing device connected to connection areas in a single component carrier, said areas connected to a separated or separable sub-portion of an electrically conductive layer structure having a region degrading along the time, allows a reliable and easily implementable component carrier health monitoring without the need of additional and/or more complicated and/or expensive solutions and/or devices.

In an example, there are four exposed connection areas at the main surface, each dedicated to be physically contacted by one of the four wires respectively. Using the architecture of the single component carrier as described above, each wire may electrically contact (through the connection area) a respective extremity of a sub-portion to be tested.

In a further embodiment, each of said extremities is electrically connected to a respective connecting area exposed on one of the main surfaces (in particular on the same) of the stack. This may provide the advantage that the result of the measurement using the measurement device is more accurate. Moreover, it may be easier to electrically connect the testing device, in particular the wires of a four-wire test device, in a reliable manner.

In an example, the electrically insulating layer structure, where the extremities of the sub-portion are connected, corresponds to an external layer (at a main surface) of the stack. In another example, the connecting areas may be located on one main surface of an internal layer of the stack. This would be the case, for example, of a testing device at least partially embedded in the single component carrier.

In a further embodiment, the sub-portion comprises at least one testing electrically conductive interconnection extending along the thickness direction (stacking direction, vertical direction z) of the stack. Thereby a robust, easy to manufacture, and efficient connection to the connecting area may be enabled.

The term "testing electrically conductive interconnection" may in this context denote an electrically conductive structure that is suitable to connect at least two electrically conductive (layer) structures (in a component carrier layer stack). In a preferred example, an electrically conductive interconnection may be a vertical electrically conductive interconnection such as a blind via in a component carrier layer stack. The testing electrically conductive interconnection may be provided on an active area of the component carrier, where the electrically conductive structures and/or one or more components may be connected or connectable one to each other through said electrically conductive interconnection. The testing electrically conductive interconnection may be suitable to be electrically tested with respect to an electric parameter (e.g. voltage, current, resistance), in particular by one or more wire(s) and/or connecting elements of a measurement apparatus. In an example, the degrading area can be a connection area/region between the sub-portion of the electrically conductive layer structure and the testing electrically conductive interconnection.

In a further embodiment, said at least one testing electrically conductive interconnection comprises two opposed extremities (in particular said two extremities correspond to the two extremities of the sub-portion). In particular, the first extremity is electrically connected to one of the at least two exposed connecting areas, and/or the second extremity is electrically connected to the other one of the at least two respective connecting areas. Thereby, an especially efficient electric contact may be enabled. Furthermore, this may bring the advantage of reliably measure the electrical value of the entire testing electrically conductive interconnection, since a testing device, for example a four-wire test device, can be connected or connectable at said two opposed extremities.

In an example, the sub-portion comprises the testing electrically conductive interconnection with the two extremities. These may be directly connected (through the stack thickness direction) to the exposed connection area. In another example, the testing electrically conductive interconnection may be a separate structure that can be electrically connected to the two extremities of the sub-portion. For example, the testing electrically conductive interconnection may thereby connect an (embedded) sub-portion to the exposed connection area.

In a further embodiment, the stack comprises at least two electrically conductive layer structures and at least two sub-portions corresponding to two electrically conductive layer structures, respectively. In particular, said sub-portions are connected one to each other through (the) at least one testing electrically conductive interconnection, and/or each of said sub-portions is connected to and/or integrated with a respective exposed connecting area. This architecture may enable an efficient and design-flexible interconnection between sub-portions for a reliable electrical testing, in particular processes well known to manufacture component carrier formed by stacked layer structures.

In an example, the sub-portions may be located at different vertical levels along the stack thickness direction. In another example, the sub-portions may be arranged at the same vertical level. In an example, the degrading area can be a connection area/region between the sub-portions of the electrically conductive layer structures and the testing electrically conductive interconnection.

In a further embodiment, the component carrier comprises: a plurality of electrically conductive interconnections in the stack, electrically connected to (the) at least one electrically conductive layer structure. In particular, said at least one testing electrically conductive interconnection has the same mechanical/chemical features and/or the same position in the depth of at least one of said plurality of electrically conductive interconnections.

The quality of the electrically conductive interconnections in a single component carrier may be estimated in an efficient, accurate, and reliable manner, when a specific architecture is provided, through the test of the testing electrically conductive interconnection provided in a dedicated test region, without affecting the functionality or the mechanical integrity of said electrically conductive interconnections and/or said electrically conductive structures and/or said one or more components.

In particular, due to the fact that the testing electrically conductive interconnection has common features with respect to (active) electrically conductive interconnections, it is possible to configure a sub-portion in proximity and with the same/similar features of other element in/on the single component carrier judged as those more sensitive/affectable by the degradation along the time; in this way it may be possible to estimate the health condition of the single component carrier concentrating the check on specific areas/components.

The term "electrically conductive interconnection" may in this context denote an electrically conductive interconnection provided on a different area of the component carrier as the testing electrically conductive interconnection, comprising comparable properties as the testing electrically conductive interconnection. In an example, the electrically conductive interconnections may be arranged at a comparable/similar vertical (along z) position in the stack (as the testing electrically conductive interconnection). In a further example, the electrically conductive interconnection comprises comparable/similar mechanical/electrical/chemical properties as the testing electrically conductive interconnection(s) and/or a comparable/similar geometry. In a preferred embodiment, all mentioned parameters may be comparable/similar.

A plurality of electrically conductive interconnections may be arranged in a layer stack. In an example, at least two electrically conductive interconnections may be arranged side by side (at least partially) on the same vertical level in the stack. Hereby, the electrically conductive interconnections may be electrically connected with each other, for example by an electrically conductive layer structure of the stack. In an example, the lower extremities of at least two electrically conductive interconnections are electrically connected by a continuous electrically conductive layer structure of the stack, while the upper extremities may be connected by a non-continuous electrically conductive layer structure.

In a further embodiment, a (electronic) component (e.g. an active or passive component, in particular a semiconductor element) is provided on the stack or is embedded in the stack. In particular, said at least one testing electrically conductive interconnection is connected to said component.

The quality of the electrically conductive interconnections in a single component carrier and its interaction (i.e. connection) with the component may be estimated in an efficient, accurate, and reliable manner, when a specific architecture is provided, through a testing electrically conductive interconnection connected to a component surface, without affecting the functionality or the mechanical integrity of said electrically conductive interconnections and/or said electrically conductive structures and/or said one or more components.

In an example, the degrading area can be a connection area/region between the component and the testing electrically conductive interconnection.

In an example, a further implementation of the concept could include the actual component or package, where the sub-portion may comprise a single solder interconnect between a component and a carrier board, and where parts of the sub-portion are located at the die or PDL and parts of the structure are located at the component carrier. If such a feature is placed at stress critical areas, e.g. at the corner of the die, then this may allow to monitor the health condition of the component carrier/die interconnects.

In a further embodiment, the single component carrier further comprises a plurality of further components (active or passive) and a plurality of electrically conductive interconnections connected to said further components, wherein said component has the area with the same mechanical/chemical features and/or the same position in the depth of the correspondent one of said plurality of further components. The quality of the plurality of the electrically conductive interconnections in a single component carrier and its interaction (i.e. connection) with the respective plurality of further component may be estimated in an efficient, accurate, and reliable manner.

Accordingly, due to the fact that the interface between the testing electrically conductive interconnection and the component has common features with respect to (active) electrically conductive interconnections with the (active) component, it is possible to configure a sub-portion in proximity and with the same/similar features of other element in/on the single component carrier judged as those more sensitive/affectable by the degradation along the time; in this way it may be possible to estimate the health condition of the single component carrier concentrating the check on specific areas/components.

In a further embodiment, one extremity, in particular each extremity, of said sub-portion and/or testing electrically conductive interconnection is connected to respective two or more connecting areas. Such a design may be especially suitable for a four-wire test.

In a further embodiment, the plurality of electrically conductive interconnections and/or the testing electrically conductive interconnection is/are configured as at least one of a blind via, a through via, a plated through hole, an interconnection between component carriers, a wire, a nanowire, a sputtered material, a solder material, an electrically conductive adhesive. This may provide the advantage that a large variety of different electrically conductive interconnections can be tested with one and the same (resistance) testing method.

In an example, the component carrier layer stack is build-up by a plurality of layers, e.g. by lamination (insulating layer structures) and plating (electrically conductive layer structures). In another example, the stack is formed by a plurality of sub-stacks that are interconnected, for example by the electrically conductive adhesive.

In a further embodiment, a plurality of sub-portions and/or testing electrically conductive interconnections are provided. This may bring the advantage of measuring electrical values related to different portions of the component carrier or electronic panel and thus evaluating the health conditions of the single component carrier in a precise and reliable manner.

In a further embodiment, the testing electrically conductive interconnections are provided in different positions with respect to the stacking direction (z) of the stack, in particular stacked one above the other. This may provide the advantage that a plurality of electrically conductive interconnections can be (individually) tested, in particular independent if they are buried deep in the stack or (partially) surface-exposed. For example, in the case of many layers or even several sub-stacks, it may be challenging to reliably test all (interesting) electrically conductive interconnections. Nevertheless, the described approach may enable such a test within different layers.

In a further embodiment, the connection between at least one of the two extremities of said sub-portion and/or the testing electrically conductive interconnection to the respective connecting area comprises at least one via interconnection. Thereby, established and approved component carrier (manufacture) techniques can be directly applied.

In a further embodiment, the connecting areas (in particular exposed connecting areas with respect to the stack) are repeatedly provided on the main surface of the electrically insulating layer structure (in particular on the main surface of the stack), thereby forming an array, in particular along linear direction(s). This may provide the advantage of the optimization of the area used for the test region. Preferably, the repetition of the connecting areas also corresponds to the repetition of the testing electrically conductive interconnections, each preferably having the two extremities connected to the respective connecting areas, leading to a more reliable health estimation due to the statistical usage of the (electrical) measures done for all the plurality of testing electrically conductive interconnections.

In a further embodiment, said testing device is mounted on or is integrated in the component carrier. This may provide the advantage that a highly versatile component carrier can be provided in a compact manner.

In a further embodiment, the test device of the package comprises a four-wire test device (see above). Thus, the simple setup of the four-wire test device may reliably measure electrical values.

In a further embodiment of the electronic panel, the stack is configured as comprising a pattern and/or several patterns of repeated features (e.g. components, electrically conductive layer structures, recesses etc.) defining a plurality of single component carries configured to be subsequently singularized in several single component carries and/or to be subsequently divided in sub-patterns. This may bring the advantages of using reliable manufacturing processes of PCB and/or IC substrate production and thus keep scrap-parts to a low value.

In a further embodiment, the electrical values correspond to or are associated with the electrical resistance values of an electric current passing through the sub-portion, in particular through a connection between the testing device and the exposed connection area(s). Thereby, the electrical resistance can be measured in a practical and reliable manner to derive information regarding the health status of the single component carrier.

In a further embodiment, the testing device is separated/separable from the single component carrier and the measurement is done through the connection between said testing device and the exposed connecting areas. For example, the testing device can be a stand-alone testing device that is automatically or manually provided to a single component carrier to be tested. This approach may be especially flexible. In other words, it is possible to use a precise and high reliable testing device to test the health of the single component carrier, but due to its cost and/or encumbrance, the single component carrier can be configured to allow a temporary contact, and then a temporary test of the carrier.

In a further embodiment, the testing device is mounted on or integrated in the single component carrier, so that the measurement is done through a fixed connection between said testing device and the exposed connecting areas. This approach may be especially practical, since the test equipment can be already integrated in the single component carrier and thus always ready and at-hand, when required. This embodiment may further allow the integration of a cheap but compact testing device, for example balancing the accuracy of the (electrical) measure with the compactness of the solution as well as the lack of the need of an external entity connection (also preferably preventing oxidation drawbacks due to the connection of the testing device).

In a further embodiment, the measurement of the electrical values of said sub-portion is done in accordance with a temporal plan. Thereby, the single component carrier health conditions can be monitored in an especially reliable manner. The temporal plan may for example include a test performance in specific time steps; for example, after a specific elapsed time, the next measurement of the electric values should be performed. This leads to a preferred possibility to evaluate the trend of the degradation of the sub-portion, and consequently the trend of the health condition of the single component carrier, allowing specific evaluations not only bound to the single and/or the instantaneous measure.

In a further embodiment, the measurement of the electrical values of said sub-portion is done through the receipt of an input command, e.g. manually by a (human) operator or automatically. This may bring the advantage of ensuring correct execute of the (electrical) measurement.

In a further embodiment, the estimation of the health condition of the single component carrier is done by combining the measured electrical values with a damage curve, in particular using stored values defining the damage curve. Such a damage curve may be a suitable means to rapidly and efficiently evaluate the health conditions based on the measured electric values. In an example, the damage curve may be a diagram that shows a correlation between electrical resistance and a health condition to be monitored, e.g. the present part of an electrical interconnection. Accordingly, the measured electric resistance may be indicative for the health condition, e.g. the remaining rest of the electrical interconnection. An exemplary embodiment of the damage curve is described for Figure 3.

In a further embodiment, the estimation of the health condition of the single component carrier comprises the estimation of the remaining time that the single component carrier complies with specific threshold conditions (e.g. to guarantee a minimum electric current passage value). This may provide the advantage that the health conditions, obtained based on the electric value measurement, can be applied in a straightforward manner for quality evaluation and planning of component carrier replacement.

In an example, one possibility to enable the measurement of the electrical resistance would be to provide the connection areas (e.g. measurement pads) at the exterior layer of the component carrier, which are accessible for manual four-wire measurement after a defined period or a defined operational load. A further option would be to connect a measurement electronics directly (e.g. SMT mounted) to the four-wires of each sub-portion (e.g. via). This would allow not only discrete measurement intervals but also a real-time monitoring of the sub-portion.

According to an exemplary embodiment, there is described a single via based health monitoring that can be implemented into component carrier design. A health condition estimation for the component carrier can be done by measuring the resistance of the single via features in a four-wire approach. The resistance is related a known resistance vs. damage curve for the implemented via diameter. This allows to estimate remaining useful life of the component carrier, and thereby optimize a maintenance schedule of critical component carriers.

According to an exemplary embodiment, it is described a health monitoring system for PCBs and substrates based on monitoring the electric resistance of single component carrier features, such as a laser via or a plated through-hole. The measurement of the single via in a four-wire setup can allow to neglect influences from the measurement setup and get just the resistance of the via or more generally the feature only. A change in the resistance of the single via is directly related to a change of the via condition. For example, an increase in the electrical resistance of the via indicates a deterioration of the via health and represents additional damage that is introduced in the material of the via over the service life of the board, e.g. by thermomechanical stress. If those vias are placed at specific and well-selected areas of the board, and the resistance monitoring is done in regular steps over time - either manually by an external measurement or automatically by e.g. SMT mounted measurement electronics, the health status of the vias can be taken as an indicator for the health status of the whole component carrier. Thus, an evaluation/estimation of remaining useful service life would be possible. This electrical resistance of each of the (relevant) single vias positioned in the component carrier can be measured in a four-wire setup. A multilayer board could for example comprise several single via coupons at different layers of the board, so that a health monitoring is possible for every single layer in the PCB.

In an embodiment, the component carrier is shaped as a plate. This contributes to the compact design, wherein the component carrier nevertheless provides a large basis for mounting components thereon. Furthermore, in particular a naked die as example for an embedded electronic component, can be conveniently embedded, thanks to its small thickness, into a thin plate such as a printed circuit board.

In an embodiment, the component carrier is configured as one of the group consisting of a printed circuit board, a substrate (in particular an IC substrate), and an interposer.

In the context of the present application, the term "printed circuit board" (PCB) may particularly denote a plate-shaped component carrier which is formed by laminating several electrically conductive layer structures with several electrically insulating layer structures, for instance by applying pressure and/or by the supply of thermal energy. As preferred materials for PCB technology, the electrically conductive layer structures are made of copper, whereas the electrically insulating layer structures may comprise resin and/or glass fibers, so-called prepreg or FR4 material. The various electrically conductive layer structures may be connected to one another in a desired way by forming holes through the laminate, for instance by laser drilling or mechanical drilling, and by partially or fully filling them with electrically conductive material (in particular copper), thereby forming vias or any other through-hole connections. The filled hole either connects the whole stack, (through-hole connections extending through several layers or the entire stack), or the filled hole connects at least two electrically conductive layers, called via. Similarly, optical interconnections can be formed through individual layers of the stack in order to receive an electro-optical circuit board (EOCB). Apart from one or more components which may be embedded in a printed circuit board, a printed circuit board is usually configured for accommodating one or more components on one or both opposing surfaces of the plate-shaped printed circuit board. They may be connected to the respective main surface by soldering. A dielectric part of a PCB may be composed of resin with reinforcing fibers (such as glass fibers).

In the context of the present application, the term "substrate" may particularly denote a small component carrier. A substrate may be a, in relation to a PCB, comparably small component carrier onto which one or more components may be mounted and that may act as a connection medium between one or more chip(s) and a further PCB. For instance, a substrate may have substantially the same size as a component (in particular an electronic component) to be mounted thereon (for instance in case of a Chip Scale Package (CSP)). In another embodiment, the substrate may be substantially larger than the assigned component (for instance in a flip chip ball grid array, FCBGA, configuration). More specifically, a substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections are arranged within the substrate and can be used to provide electrical, thermal and/or mechanical connections of housed components or unhoused components (such as bare dies), particularly of IC chips, with a printed circuit board or intermediate printed circuit board. Thus, the term "substrate" also includes "IC substrates". A dielectric part of a substrate may be composed of resin with reinforcing particles (such as reinforcing spheres, in particular glass spheres).

The substrate or interposer may comprise or consist of at least a layer of glass, silicon (Si) and/or a photoimageable or dry-etchable organic material like epoxy-based build-up material (such as epoxy-based build-up film) or polymer compounds (which may or may not include photo- and/or thermosensitive molecules) like polyimide or polybenzoxazole.

In an embodiment, the at least one electrically insulating layer structure comprises at least one of the group consisting of a resin or a polymer, such as epoxy resin, cyanate ester resin, benzocyclobutene resin, bismaleimide-triazine resin, polyphenylene derivate (e.g. based on polyphenylenether, PPE), polyimide (PI), polyamide (PA), liquid crystal polymer (LCP), polytetrafluoroethylene (PTFE) and/or a combination thereof. Reinforcing structures such as webs, fibers, spheres or other kinds of filler particles, for example made of glass (multilayer glass) in order to form a composite, could be used as well. A semi-cured resin in combination with a reinforcing agent, e.g. fibers impregnated with the above-mentioned resins is called prepreg. These prepregs are often named after their properties e.g. FR4 or FR5, which describe their flame retardant properties. Although prepreg particularly FR4 are usually preferred for rigid PCBs, other materials, in particular epoxy-based build-up materials (such as build-up films) or photoimageable dielectric materials, may be used as well. For high frequency applications, high-frequency materials such as polytetrafluoroethylene, liquid crystal polymer and/or cyanate ester resins, may be preferred. Besides these polymers, low temperature cofired ceramics (LTCC) or other low, very low or ultra-low DK materials may be applied in the component carrier as electrically insulating structures.

In an embodiment, the at least one electrically conductive layer structure comprises at least one of the group consisting of copper, aluminum, nickel, silver, gold, palladium, tungsten, magnesium, carbon, (in particular doped) silicon, titanium, and platinum. Although copper is usually preferred, other materials or coated versions thereof are possible as well, in particular coated with supra-conductive material or conductive polymers, such as graphene or poly(3,4-ethylenedioxythiophene) (PEDOT), respectively.

At least one further component may be embedded in and/or surface mounted on the stack. The component and/or the at least one further component can be selected from a group consisting of an electrically non-conductive inlay, an electrically conductive inlay (such as a metal inlay, preferably comprising copper or aluminum), a heat transfer unit (for example a heat pipe), a light guiding element (for example an optical waveguide or a light conductor connection), an electronic component, or combinations thereof. An inlay can be for instance a metal block, with or without an insulating material coating (IMS-inlay), which could be either embedded or surface mounted for the purpose of facilitating heat dissipation. Suitable materials are defined according to their thermal conductivity, which should be at least 2 W/mK. Such materials are often based, but not limited to metals, metal-oxides and/or ceramics as for instance copper, aluminium oxide (Al₂O₃) or aluminum nitride (AIN). In order to increase the heat exchange capacity, other geometries with increased surface area are frequently used as well. Furthermore, a component can be an active electronic component (having at least one p-n-junction implemented), a passive electronic component such as a resistor, an inductance, or capacitor, an electronic chip, a storage device (for instance a DRAM or another data memory), a filter, an integrated circuit (such as field-programmable gate array (FPGA), programmable array logic (PAL), generic array logic (GAL) and complex programmable logic devices (CPLDs)), a signal processing component, a power management component (such as a field-effect transistor (FET), metal-oxide-semiconductor field-effect transistor (MOSFET), complementary metal-oxide-semiconductor (CMOS), junction field-effect transistor (JFET), or insulated-gate field-effect transistor (IGFET), all based on semiconductor materials such as silicon carbide (SiC), gallium arsenide (GaAs), gallium nitride (GaN), gallium oxide (GazOs), indium gallium arsenide (InGaAs), indium phosphide (InP) and/or any other suitable inorganic compound), an optoelectronic interface element, a light emitting diode, a photocoupler, a voltage converter (for example a DC/DC converter or an AC/DC converter), a cryptographic component, a transmitter and/or receiver, an electromechanical transducer, a sensor, an actuator, a microelectromechanical system (MEMS), a microprocessor, a capacitor, a resistor, an inductance, a battery, a switch, a camera, an antenna, a logic chip, and an energy harvesting unit. However, other components may be embedded in the component carrier. For example, a magnetic element can be used as a component. Such a magnetic element may be a permanent magnetic element (such as a ferromagnetic element, an antiferromagnetic element, a multiferroic element or a ferrimagnetic element, for instance a ferrite core) or may be a paramagnetic element. However, the component may also be a IC substrate, an interposer or a further component carrier, for example in a board-in-board configuration. The component may be surface mounted on the component carrier and/or may be embedded in an interior thereof. Moreover, also other components, in particular those which generate and emit electromagnetic radiation and/or are sensitive with regard to electromagnetic radiation propagating from an environment, may be used as component.

In an embodiment, the component carrier is a laminate-type component carrier. In such an embodiment, the component carrier is a compound of multiple layer structures which are stacked and connected together by applying a pressing force and/or heat.

After processing interior layer structures of the component carrier, it is possible to cover (in particular by lamination) one or both opposing main surfaces of the processed layer structures symmetrically or asymmetrically with one or more further electrically insulating layer structures and/or electrically conductive layer structures. In other words, a build-up may be continued until a desired number of layers is obtained.

After having completed formation of a stack of electrically insulating layer structures and electrically conductive layer structures, it is possible to proceed with a surface treatment of the obtained layers structures or component carrier.

In particular, an electrically insulating solder resist may be applied to one or both opposing main surfaces of the layer stack or component carrier in terms of surface treatment. For instance, it is possible to form such a solder resist on an entire main surface and to subsequently pattern the layer of solder resist so as to expose one or more electrically conductive surface portions which shall be used for electrically coupling the component carrier to an electronic periphery. The surface portions of the component carrier remaining covered with solder resist may be efficiently protected against oxidation or corrosion, in particular surface portions containing copper.

It is also possible to apply a surface finish selectively to exposed electrically conductive surface portions of the component carrier in terms of surface treatment. Such a surface finish may be an electrically conductive cover material on exposed electrically conductive layer structures (such as pads, conductive tracks, etc., in particular comprising or consisting of copper) on a surface of a component carrier. If such exposed electrically conductive layer structures are left unprotected, then the exposed electrically conductive component carrier material (in particular copper) might oxidize, making the component carrier less reliable. A surface finish may then be formed for instance as an interface between a surface mounted component and the component carrier. The surface finish has the function to protect the exposed electrically conductive layer structures (in particular copper circuitry) and enable a joining process with one or more components, for instance by soldering. Examples for appropriate materials for a surface finish are Organic Solderability Preservative (OSP), Electroless Nickel Immersion Gold (ENIG), Electroless Nickel Immersion Palladium Immersion Gold (ENIPIG), Electroless Nickel Electroless Palladium Immersion Gold (ENEPIG), gold (in particular hard gold), chemical tin (chemical and electroplated), nickel-gold, nickel-palladium, etc. Also nickel-free materials for a surface finish may be used, in particular for high-speed applications. Examples are ISIG (Immersion Silver Immersion Gold), and EPAG (Electroless Palladium Autocatalytic Gold).

### Brief Description of the Drawings

The aspects defined above and further aspects of the invention are apparent from the examples of embodiment to be described hereinafter and are explained with reference to these examples of embodiment.
Figure 1 illustrates a sub-portion of an electrically conductive layer structure in a component carrier layer stack according to an exemplary embodiment of the invention.
Figure 2 illustrates a single component carrier with a sub-portion of an electrically conductive layer structure according to an exemplary embodiment of the invention.
Figure 3 illustrates a damage-curve according to an exemplary embodiment of the invention.
Figures 4 illustrates a testing device according to an exemplary embodiment of the invention.
Figure 5 illustrates a cross-section of a single component carrier with an embedded component according to an exemplary embodiment of the invention.
Figure 6 illustrates a top view on the exposed connection areas at a main surface of a single component carrier according to exemplary embodiments of the invention.

### Detailed Description of the Drawings

The illustration in the drawing is schematic. It is noted that in different figures, similar or identical elements or features are provided with the same reference signs or with reference signs, which are different from the corresponding reference signs only within the first digit. In order to avoid unnecessary repetitions elements or features which have already been elucidated with respect to a previously described embodiment are not elucidated again at a later position of the description.

Further, spatially relative terms, such as "front" and "back", "upper" and "lower", "left" and "right", et cetera are used to describe an element's relationship to another element(s) as illustrated in the figures. Thus, the spatially relative terms may apply to orientations in use which differ from the orientation depicted in the figures. Obviously all such spatially relative terms refer to the orientation shown in the figures only for ease of description and are not necessarily limiting.

**Figure 1** illustrates a cross section view of a single component carrier 100 comprising a layer stack 101 comprising electrically conductive layer structures 130, 131, electrically insulating layer structures 102, and a surface finish (in particular solder resist) 103 according to an exemplary embodiment of the invention. The lower electrically insulating layer structure 102 can also be implemented as an embedded component 180. One of the electrically conductive layer structures 130, 131 comprises a sub-portion 150, wherein said sub-portion 150 is electrically separated or separable from the rest of said electrically conductive layer structures. The sub-portion 150 comprises a region 155 degrading along the time, which is in this example a part of a via interconnection. In an embodiment, the region 155 degrading along the time can also be connected to a testing electrical interconnection 125 that can also be configured as a via.

The sub-portion 150 and/or the testing electrical interconnection 125 comprises two extremities, and each of said extremities is electrically connected, in this example via the electrically conductive layer structures 130 and 131, to respective connecting areas 140, exposed on the same main surface of the electrically insulating layer structure 102. Said main surface is further located at the upper exterior main surface of the stack 101.

In a specific example, the testing electrically conductive interconnection 125 may be provided with the same mechanical/chemical features and/or the same position in the depth of at least one of a plurality of electrically conductive interconnections 120, 121. Said testing electrically conductive interconnection 125 may be configured as a blind via, e.g. formed by laser drilling which manufacture method results in the tapered shape. The upper part of the testing electrically conductive interconnection 125 can be termed "first extremity". The lower part of the testing electrically conductive interconnection 125 is opposite to the first extremity and is termed "second extremity". Said second extremity may be embedded in the layer stack 101 and may be (electrically) connected to a component 180.

In a preferred example, the electrically conductive interconnections 120, 121 and the testing electrically conductive interconnection 125 as well as the electrically conductive layer structures 130, 131 may comprise at least one metal, in particular copper or a copper alloy. Additionally, the electrically conductive interconnections 120, 121 and the testing electrically conductive interconnection 125 as well as the electrically conductive layer 130, 131 may comprise a surface finish, in particular gold. In another example, the electrically conductive interconnections 120, 121 and the testing electrically conductive interconnection 125 when exposed on a main surface may be indented beneath the surface. Alternatively, the electrically conductive interconnections 120, 121 and the testing electrically conductive interconnection 125 when exposed on a main surface may be flush with the main surface.

Schematically shown in Figure 1 is a measurement device 160, 170, i.e. for a four-wire test, comprising four connecting wires that are moved to put in (direct) contact with the exposed connection areas 140 connected to the three electrically conductive interconnections 120, 121, 125 for the test of the testing electrically conductive interconnection 125. In particular, there are a first wire and a second wire of a current measurement device (e.g. ammeter/amperemeter) 160 respectively connected to an exposed connection area and a further exposed connection area and a third and a fourth wire of a voltage measurement device (e.g. voltmeter) 170 respectively connected to said further and another exposed connection area.

Due to the fact that the testing electrically conductive interconnection 125 has the first extremity aligned and/or exposed to the main surface of the component carrier, a respective one of both the current measurement device 160 and the voltage measurement device 170 are directly put in connection with this first extremity. On the other hand, being the second extremity of said testing electrically conductive interconnection 125 embedded in the single component carrier 100, the connection with the respective further wires of the current measurement device 160 and the voltage measurement device 170 is provided through the electrical connection with the second extremity and with one of the other two electrically conductive interconnections 120, 121, each of those preferably having one extremity exposed to the same (single) component carrier main surface where the first extremity of the testing electrically conductive interconnection 125 is exposed, then resulting to the exposure of all the surfaces needed to connect the wires of the measurement device 160, 170 on the same area of the single component carrier 100, to provide the electrical connection with both extremities of the testing electrically conductive interconnection 125.

**Figure 2** illustrates a single component carrier 100 with a sub-portion 150 of an electrically conductive layer structure 104 according to an exemplary embodiment of the invention. The exterior main surface of the single component carrier 100 comprises a patterned (discontinuous) electrically conductive layer structure 104. Sub-portions 150 of said electrically conductive layer structure 104, e.g. important via interconnections to be monitored (measurement via), comprise respective regions 155 degrading over time. As shown in the detailed view, such a sub-portion 150 can be electrically connected at its extremities to connection areas 140 exposed at the component carrier external main surface.

In this specific example, the exposed connection areas are configured as pads with the following functionalities: U- pad (voltage drop measurement) 141, U+ pad (voltage drop measurement) 142, current source pad 143, current drain pad 144. In a preferred example, the U+ pad 142 and the current source pad 143 may be connected to the first extremity of the important via interconnection, for example the testing electrically conductive interconnection 125. Furthermore, the U- pad 141 and the current drain pad 144 may be connected to the second extremity of the important via interconnection, for example the testing electrically conductive interconnection 125. In another example, the sub-portion may be located in a central portion and/or peripheral portion of the single component carrier 100. Even though the architecture of Figure 2 has been described for the example of a component carrier 100, it can also be applied to a package and/or an electronic panel (see specification above).

**Figure 3** illustrates a damage-curve according to an exemplary embodiment of the invention. In this exemplary diagram, the x-axis shows the electrical resistance (in mOhm), while the y-axis shows in percent (%) the rest of a via interconnection (seen in cross section). The experimentally determined or simulated damage curve associates specific electric values (which can be measured, e.g. using the four-wire test) with a health status of the via interconnection. In the present example, said via interconnection is the region degrading along the time 155 of the sub-portion 150. It can be seen from the damage curve that an intact via (100%; in this example ~200 mOhm) has a quite low resistance. In comparison, a damaged via (e.g. only 50% remaining after degradation, in this example ~300 mOhm) has a much higher resistance. The more the via degrades (loses material in the cross-section), the higher will be the resistance value, and accordingly, the signal transmission quality will drop significantly. Thus, a measured electric value with respect to the sub-portion 150 can be directly linked to the health condition of the sub-portion 150, which can then be extrapolated to a health condition of the whole single component carrier 100.

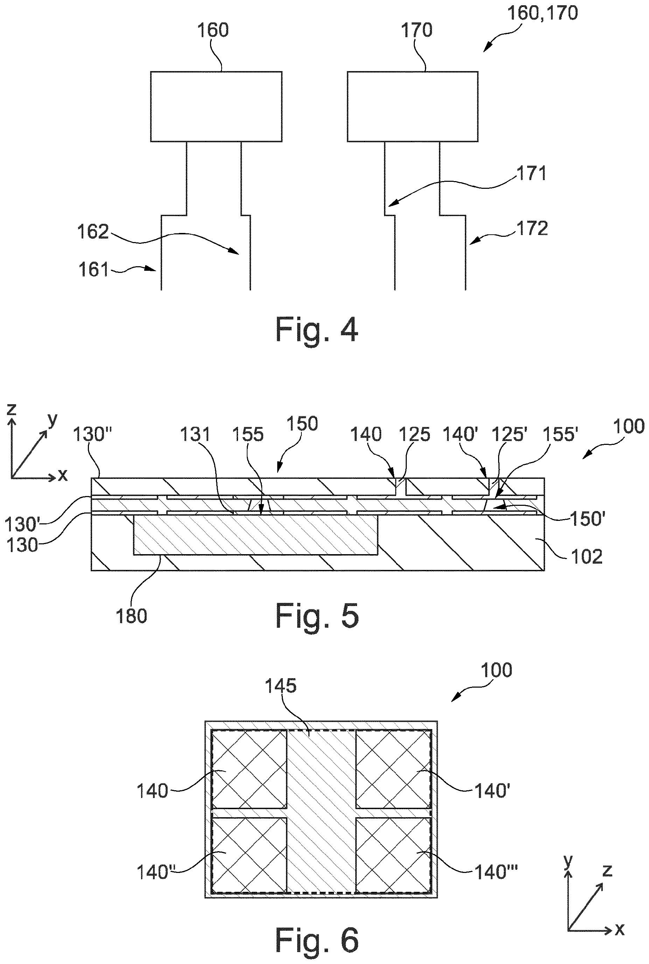

**Figure 4** illustrates a current measurement device 160 and a voltage measurement device 170 (testing device) according to an exemplary embodiment of the invention. As already described above, the current measurement device 160 comprises a first wire 161 and a second wire 162 to electrically contact at least one connection area 140. Accordingly, the voltage measurement device 170 comprises a third wire 171 and a fourth wire 172 to electrically contact at least one further connection area 140. The current measurement device 160 and the voltage measurement device 170 can be implemented in a common apparatus that is configured to perform a four-wire-test measurement.

**Figure 5** illustrates another cross-section view of a single component carrier 100 with a sub-portion 150 in the stack 101 according to a further exemplary embodiment of the invention. Differently from the previous embodiment, the sub-portion 150 is fully embedded/buried in the component carrier 100, so that also the upper extremity cannot be directly connected to the exposed connection area 140.

In this example, three electrically conductive layer structures 130, 130', 130" are provided on three different vertical component carrier positions above an embedded component 180. The sub-portion 150 is in this example a via interconnection located/sandwiched between two electrically conductive layer structures 130 and 130', and electrically connected to said structures by the two extremities. The sub-portion 150 comprises a region/portion 155 degrading over time that is a connection to the embedded component 180. The sub-portion 150 further comprises a testing electrically conductive interconnection 125, also configured as a via interconnection, that is electrically connected to the sub-portion 150 by said electrically conductive layer structures 130, 130'. The testing electrically conductive interconnection 125 is further electrically connected to the third electrically conductive layer structure 130" at an exposed connection area 140 at the exterior main surface of the stack 101/electrically insulating layer structure 102.

When the exposed connection area 140 is now contacted by a testing device 160, 170, an electric value indicative of the sub-portion 150 can be measured. Based on said measurement, the health condition of the single component carrier 100 can be evaluated. A further sub-portion 150' is directly connected to a respective further testing electrically conductive interconnection 125' via a further area 155' degrading over time.

**Figure 6** illustrates a top view on a single component carrier 100 exterior main surface according to an exemplary embodiment of the invention. In this example, the exposed connection areas 140 and 140' are connected with the first extremity and the exposed connection areas 140" and 140‴ are connected to the second extremity. Said four exposed areas 140, 140', 140", 140‴ preferably have an array disposition 145 on the main surface area of the single component carrier 100, preferably each comprising a quadrangular-shaped connection area. Each element of said array 145 (connection area, further connection area, other connection area) may have similar/same mechanical/chemical features. Even though the architecture of Figure 6 has been described for the example of a component carrier 100, it can also be applied to a package and/or an electronic panel (see specification above).

By connecting said first and second wire of said current measurement device 160 and said third and fourth wire of said voltage measurement device 170 to each one of said connection areas 140 so that each of both the current measurement device 160 and voltage measurement device 170 are electrically connected to both the extremities, at least one electrical value may be acquired.

### Reference signs

- 100: component carrier
- 101: stack
- 102: electrically insulating layer structure
- 103: surface finish
- 104: electrically conductive layer structure
- 120: electrically conductive interconnection
- 121: further electrically conductive interconnection
- 125: testing electrically conductive interconnection
- 130: electrically conductive layer structure
- 131: electrically conductive layer structure
- 140: exposed connecting area
- 141-144: Pads
- 145: array
- 150: sub-portion
- 155: region degrading along the time
- 160: current measurement device
- 170: voltage measurement device
- 180: component

## Claims

1. A single component carrier (100), comprising
a stack (101) having at least one electrically conductive layer structure (104) and at least one electrically insulating layer structure (102);
wherein the at least one electrically conductive layer structure (104) comprises a sub-portion (150),
wherein said sub-portion (150) is electrically separated or separable from the rest of said electrically conductive layer structure (104),
wherein said sub-portion (150) comprises a region (155) degrading along the time,
wherein said sub-portion (150) comprises two extremities, and
wherein each of said extremities is electrically connected to a respective connecting area (140) on one of the main surfaces of the at least one electrically insulating layer structure (102).

2. The single component carrier (100) according to claim 1,
wherein the sub-portion (150) comprises at least one testing electrically conductive interconnection (125) extending along the thickness direction (z) of the stack (101).

3. The single component carrier (100) according to claim 2, wherein the component carrier (100) comprises:
a plurality of electrically conductive interconnections (120, 121) in the stack (101), electrically connected to at least one electrically conductive layer structure (104),
wherein said at least one testing electrically conductive interconnection (125) has the same mechanical/chemical features and/or the same position in the depth of at least one of said plurality of electrically conductive interconnections (120, 121).

4. The single component carrier according to claim 2 or 3,
wherein a component (180) is provided on the stack (101) or is embedded in the stack (101),
wherein said at least one testing electrically conductive interconnection (125) is connected to said component (180).

5. The single component carrier (100) according to claim 4, further comprising:
a plurality of further components and a plurality of electrically conductive interconnections (120, 121) connected to said further components, wherein said component (180) has the area with the same mechanical/chemical features and/or the same position in the depth of the correspondent one of said plurality of further components.

6. The single component carrier (100) according to any one of claims 1 to 5, wherein the connection between at least one of the two extremities of said sub-portion (150) and/or the testing electrically conductive interconnection (125) to the respective connecting area (140, 141) comprises at least one via interconnection.

7. A package, said package comprising a single component carrier (100) according to any of the claims 1 to 6 and a testing device (160, 170),
wherein said testing device (160, 170) is electrically connected and/or connectable to the connecting areas (140, 141).

8. The package according to claim 7,
wherein said testing device (160, 170) comprises a four-wire test device.

9. An electronic panel, comprising a stack comprising at least one electrically conductive layer structure and at least one electrically insulating layer structure, and configured to be subsequently singularized in several single component carries (100) each configured according to any one of the claims 1 to 6.

10. A method to evaluate the health condition of a single component carrier (100), said single component carrier (100) comprising a stack (101) comprising at least one electrically conductive layer structure (104) and at least one electrically insulating layer structure (102), wherein a sub-portion (150) of the at least one electrically conductive layer structure (104) comprises a region (155) degrading along the time, wherein said sub-portion (150) comprises two extremities, and wherein each of said extremities is connected to a respective connecting area (140, 141)) provided on one of the main surfaces of the at least one electrically insulating layer structure (102),
said method comprising:
providing a testing device (160, 170) and connecting said testing device (160, 170) to said respective connecting areas (140, 141);
measuring electrical values associated with said sub-portion (150); and
evaluating the health condition of the single component carrier (100) based on the measured electrical values.

11. The method according to claim 10,
wherein the electrical values correspond to or are associated with the electrical resistance values of an electric current passing through the sub-portion (150).

12. The method according to claim 10 or 11,
wherein the measurement of the electrical values of said sub-portion (150) is done in accordance with a temporal plan.

13. The method according any one of claims 10 to 12,
wherein the evaluation of the health condition of the single component carrier (100) is done by combining the measured electrical values with a damage curve.

14. A computer-readable medium, in which a computer program of assessing the health of a single component carrier is stored, which computer program, when being executed by one or a plurality of processors, is adapted to carry out or control a method according to any of claims 10 to 13.

15. A program element of assessing the health of a single component carrier, which program element, when being executed by one or a plurality of processors, is adapted to carry out or control a method according to any of claims 10 to 13.
